(19) Europäisches Patentamt
European Patent Office
Office européen des brevets

(11) EP 0 422 170 B1

(12) # EUROPÄISCHE PATENTSCHRIFT

(45) Veröffentlichungstag und Bekanntmachung des Hinweises auf die Patenterteilung:
**15.01.1997 Patentblatt 1997/03**

(21) Anmeldenummer: **90906126.9**

(22) Anmeldetag: **27.04.1990**

(51) Int Cl.6: **G01R 33/46**, G01R 33/48, G01R 33/56

(86) Internationale Anmeldenummer:
**PCT/DE90/00308**

(87) Internationale Veröffentlichungsnummer:
**WO 90/13825 (15.11.1990 Gazette 1990/26)**

(54) **VERFAHREN ZUR AUFNAHME VON SPINRESONANZSPEKTREN**

A PROCESS FOR RECORDING SPIN RESONANCE SPECTRA

PROCEDE D'ENREGISTREMENT DE SPECTRES DE RESONANCE DE SPINS

(84) Benannte Vertragsstaaten:
**CH FR GB LI NL**

(30) Priorität: **29.04.1989 DE 3914302**
**31.05.1989 AU 4467/89**

(43) Veröffentlichungstag der Anmeldung:
**17.04.1991 Patentblatt 1991/16**

(73) Patentinhaber: **UNIVERSITY OF QUEENSLAND**
**St Lucia, Queensland 4067 (AU)**

(72) Erfinder:
- **DODDRELL, David Michael**
  **Westlake, QLD 4074 (AU)**
- **GALLOWAY, Graham John**
  **Runcorn, QLD 4113 (AU)**
- **BRERETON, Ian Malcolm**
  **Auchenflower, QLD 4066 (AU)**

(74) Vertreter: **Witte, Alexander, Dr.-Ing. et al**
**Witte, Weller, Gahlert, Otten & Steil,**
**Patentanwälte,**
**Rotebühlstrasse 121**
**70178 Stuttgart (DE)**

(56) Entgegenhaltungen:
**US-A- 4 680 546** **US-A- 4 701 708**

- **JOURNAL OF MAGNETIC RESONANCE, Band 81, Nr. 3, 15. Februar 1989, Academic Pres, Inc., (Duluth, MN, US); A. KNüTTEL et al.: "Single-Scan Volume-Selective Editing of 1H Signals for the Indirect Detection of Coupled X Nuclei", Seiten 570-576**
- **JOURNAL OF MAGNETIC RESONANCE, Band 75, Nr. 2, November 1987, Academic Press, Inc., (Duluth, MN, US); V. SKLENAR et al.: "Water suppression using a combination of hard and soft pulses", Seiten 352-357**
- **MAGNETIC RESONANCE IN MEDICINE, Band 8, Nr. 3, November 1988, Academic Press, Inc., (Duluth, MN, US); G.C. McKINNON et al.: "A One-Shot Lactate-Editing Sequence for Localized Whole-Body Spectroscopy", Seiten 335-361**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 422 170 B1

Printed by Jouve, 75001 PARIS (FR)

## Beschreibung

Die erfindung betrifft ein Verfahren zur Aufnahme von Kernspinresonanzspektren von Proben mit mindestens zwei Gruppen von Kernen derselben Kernart, die über eine Kopplung miteinander wechselwirken wobei zur alleinigen Darstellung des Signals einer Gruppe, z.B $CH_3$, das Signal der anderen Gruppe, z.B CH, unterdrückt wird.

In der Technik der Spinresonanz-Spektroskopie ist es bekannt, Spektren, bei denen Signale verschiedener Kerngruppen einander überlagern, zu "editieren". Hierunter versteht man verschiedene Aufnahmetechniken, mit denen es möglich ist, aus überlagerten Spektren Einzelsignale herauszufiltern. Üblicherweise geschieht dies, indem nacheinander mehrere Messungen mit unterschiedlichen Meßparametern ausgeführt und dann unerwünschte Signalanteile durch Differenzbildung eliminiert werden.

Beispiele derartiger Editiertechniken für Kernresonanz-Anwendungen sind in dem Lehrbuch von Sanders, Jeremy K.M. und Brian K. Hunter "Modern NMR Spectroscopy", Oxford University Press, 1987, Seiten 237 bis 259 beschrieben. Weitere derartige Verfahren sind in der EP-OS 244 752 und der EP-OS 166 559 beschrieben. Bei diesen weiteren bekannten Verfahren werden ungekoppelte Spins durch Differenzbildung zweier Messungen unterdrückt.

Die vorstehend beschriebenen Editiertechniken haben jedoch den gemeinsamen Nachteil, daß zur Aufnahme eines Spektrums mehrere, zeitlich versetzte Messungen mit unterschiedlichen Meßparametern durchgeführt werden müssen. Während dies bei langlebigen chemischen Proben in einem Labor kein wesentliches Problem darstellt, können sich erhebliche Probleme dann ergeben, wenn derartige Kernresonanzspektren an biologischen Proben, nämlich an lebendem Gewebe durchgeführt werden sollen. Dies gilt vor allem dann, wenn in-vivo-Messungen an Patienten durchgeführt werden und Bewegungsartefakte zu Meßwertverfälschungen führen können.

Differenzbildende Meßverfahren haben ferner den prinzipiellen Nachteil, daß infolge der Subtraktion von hohen Störsignalamplituden Meßfehler auftreten können, die in derselben Größenordnung liegen wie das Nutzsignal.

Es ist auch bekannt, Kernresonanzspektren volumenselektiv, d.h. nur für einen bestimmten, räumlich definierten Bereich einer Probe aufzunehmen. Diese Aufnahmetechnik hat besondere Bedeutung in der biologischen Forschung sowie der Medizin. Mit dieser Aufnahmetechnik ist es nämlich möglich, beispielsweise an einem Patienten ein Kernresonanzspektrum eines bestimmten definierten Punktes in einem inneren Organ des Patienten aufzunehmen.

Die Aufnahme von volumenselektiven Kernresonanzspektren ist eine an sich bekannte Technik, Beispiele finden sich im Lehrbuch von Wehrli, Felix W., Derek Shaw und J. Bruce Kneeland "Biomedical Magnetic Resonance Imaging", Verlag Chemie, 1988, Seiten 1 bis 45 und 521 bis 545.

Aus der US-Z "Journal of Magnetic Resonance", 67 (1986), Seite 148, ist z.B. das sogenannte SPARS-Verfahren und aus der US-Z "Journal of Magnetic Resonance", 68 (1986), Seite 367, ist das sogenannte DIGGER-Verfahren bekannt. Bei diesen bekannten Verfahren handelt es sich um volumenselektive Verfahren, bei denen die Schichten außerhalb des selektierten Volumenbereiches gesättigt werden, so daß nur noch der selektierte Volumenbereich übrig bleibt. Nachteilig bei diesen beiden bekannten Verfahren, insbesondere beim DIGGER-Verfahren, ist, daß eine hohe Hochfrequenzleistung benötigt wird, und bei beiden genannten Verfahren müssen die VorsättigungsHochfrequenzpulse sehr genau eingestellt werden, weil sonst zusätzliche Signale erzeugt werden.

Ein weiteres spezielles Verfahren zur volumenselektiven Aufnahme von Kernresonanzspektren unter Verwendung von drei zeitlich beabstandeten 90°-Hochfrequenz-Impulsen bei gleichzeitigem Anliegen verschiedener Gradienten-Magnetfeld-Impulse in unterschiedlichen Koordinatenrichtungen ist auch in der DE-OS 34 45 689 beschrieben. Bei diesem bekannten Verfahren werden herkömmliche stimulierte Spin-Echos erzeugt.

Aus der US-Z "Magnetic Resonance in Medicine", 9 (1989), Seiten 254 bis 260, ist es schließlich bekannt, volumenselektive Spektren unter Verwendung eines homonuklearen Polarisationstransfers zu editieren, wobei ein einmaliger Transfer verwendet wird.

Wenn nun das Kernresonanzspektrum an einem homonuklear oder heteronuklear gekoppelten Spinsystem der allgemeinen Form $A_nX_m$ aufgenommen werden soll, wie dies für die biomedizinische Forschung von großem Interesse ist, weil derartige Messungen Rückschlüsse auf den Metabolismus im organischen Gewebe erlauben, so stellt sich oft das Problem der Signalüberlappung. Bei einem homonuklear gekoppelten Spinsystem bestehen beide Kopplungspartner aus derselben Kernart, z.B. aus Protonen ($^1H$), während bei heteronuklear gekoppelten Spinsystemen die Kopplungspartner zu verschiedenen Kernarten gehören, z.B. die A-Gruppe zu den Protonen ($^1H$) und die X-Gruppe zu einem Kohlenstoff-Isotop ($^{13}C$). Bei einem homonuklearen Beispielsfall von Lactat, einem $A_3X$-System, hat z.B. die Methylgruppe ($CH_3$) in etwa dieselbe chemische Verschiebung, d.h. Lage der Linie im Spektrum, wie die $CH_2$-Gruppe von Lipid, weil beide chemischen Verschiebungen ungefähr bei 1,35 ppm liegen. Da die Lipidkonzentration in lebendem Gewebe jedoch wesentlich größer sein kann, verdeckt das $CH_2$-Signal des Lipids das $CH_3$-Signal des Lactats. Entsprechendes gilt allgemein für die Editierung von heteronuklearen $A_nX_m$-Systemen, z.B. für ein $A_3X$-System wie Methanol mit $^{13}C$-Anreicherung.

Würde man nun im erstgenannten Beispielsfall eine volumenselektive Lactat-Messung in einer Lipid-Umgebung mit den bekannten Editierungstechniken vornehmen, bei denen, wie erwähnt, zwei Messungen in zeitlicher Folge mit unterschiedlichen Parametern vorgenommen werden müssen, so ergäben sich Probleme dann, wenn sich der Patient

während dieser beiden Messungen bewegt. Es entstehen dann nämlich Artefakte, durch die beide Messungen unterschiedlich beeinflußt werden, so daß bei einer anschließenden Differenzbildung nicht nur die gewünschten isolierten $CH_3$-Signale des Lactats, sondern auch die unerwünschten Lipid-Artefakte durch Editieren herauspräpariert werden.

Die Erfindung wird am einfachen Beispiel der skalaren Kopplung (J) dargestellt, es versteht sich jedoch, daß Anwendungen auch bei anderen Kopplungsarten, z.B. der Dipolkopplung, möglich sind.

Es ist ferner zum selektiven Editieren von Metaboliten-Signalen bekannt, Mehrquanten-Übergänge (MQ) oder Nullquanten-Übergänge (ZQ) auszunutzen. Beispiele hierzu finden sich in der US-Z "Journal of Magnetic Resonance", 64 (1985), Seite 38, in der US-Z "Journal of Magnetic Resonance", 78 (1988), Seite 355, in der US-Z "Journal of Magnetic Resonance", 77 (1988), Seite 382, und der US-Z "Magnetic Resonance in Medicine", 9 (1989), Seite 32.

Der wesentliche Nachteil differenzbildender Methoden liegt in ihrer Abhängigkeit von einer präzisen Subtraktion. Dies ist ein wesentlicher Gesichtspunkt bei in-vivo-Messungen, bei denen dominierende Resonanzen von Wasser und Lipid auftreten können. Ein weiterer Nachteil ist die Notwendigkeit zwei-dimensionaler Messungen, um das Metaboliten-Signal zu extrahieren. Bei einem bekannten ein-dimensionalen Verfahren wurden eine selektive Anregung und gepulste Feldgradienten eingesetzt, um ausschließlich Nullquanten-Kohärenzen auszuwählen, so daß mit einer einzigen Messung eine gute spektrale Editierung und eine Unterdrückung von Lösungsmitteln möglich war. Allerdings haben diese Verfahren den wesentlichen Nachteil, daß ein Verlust an Signal-Rausch-Verhältnis eintritt, weil immer sowohl Nullquanten- wie auch Mehrquanten-Kohärenzen angeregt werden, aber nur jeweils eine dieser Kohärenzen in ein beobachtbares Ein-Quanten-Signal (SQ) umgeformt wird, während das jeweils andere durch einen Feldgradienten dephasiert oder durch Umschalten der Phase eliminiert wird. Wenn Nullquanten-Kohärenzen ausgewählt werden, steht nur höchstens ein Viertel der Kohärenz für eine nachfolgende Anwendung von Feldgradienten zur Verfügung, und die Effektivität einer gewünschten Ausbildung von Mehrquanten-Kohärenzen kann von der Vielzahl von Spin-Spin-Kopplungen abhängen, beispielsweise im Falle von Ethanol, bei dem Einquanten- und Dreiquanten-Anteile (SQ, TQ) verloren gehen. Es ist auch vorgeschlagen worden, selektive Polarisationstransfer-Verfahren einzusetzen, aber auch diese führen zu einem Signalverlust infolge der Richtung des Transfers oder infolge der Abhängigkeit des Polarisationstransfers vom Hochfrequenz-Pulswinkel und erfordern daher eine umfangreiche zyklische Umschaltung der Phase. Näheres zu den letztgenannten Effekten ist in der US-Z "Journal of Magnetic Resonance", 66 (1986), Seite 86, sowie in der US-Z "Progress in NMR Spectro-scopy", 16 (1983), Seite 163, zu finden.

Aus der US-PS 4 521 732 ist weiterhin bekannt, auf eine Probe, die mindestens zwei verschiedene Kernarten enthält, aufeinanderfolgende Hochfrequenz-Impulse einzustrahlen, wobei der erste und dritte Impuls selektiv auf die eine Kernart einwirken und der zweite Impuls selektiv auf die andere Kernart, und wobei zwischen aufeinanderfolgenden Impulsen Zeitspannen liegen, die so bemessen sind, daß sich eine heteronukleare skalare Kopplungswechselwirkung entfalten kann.

Aus der US-PS 4 680 546, der US-PS 4 238 735 sowie der US-PS 4 703 270 sind schließlich weitere Pulssequenzen zur Untersuchung heteronuklearer Systeme bekannt.

Der Erfindung liegt demgegenüber die Aufgabe zugrunde, ein Verfahren der eingangs genannten Art dahingehend weiterzubilden, daß ein Editieren gewünschter Spektralanteile mit nur einer Messung möglich ist, ohne dabei Signalamplitude einzubüßen.

Diese Aufgabe wird erfindungsgemäß dadurch gelöst,

- daß eine Impulsfolge von vier Hochfrequenz-Impulsen, vorzugsweise 90°-Hochfrequenz-Impulsen, auf die Probe eingestrahlt wird,
- daß der erste Hochfrequenz-Impuls ein für die Kerne der ersten Gruppe selektiver, weicher Impuls ist, dessen Mittenfrequenz mit der Resonanzfrequenz der ersten Gruppe übereinstimmt,
- daß der zweite Hochfrequenz-Impuls ein für die Kerne der zweiten Gruppe selektiver, weicher Impuls ist, dessen Mittenfrequenz mit der Resonanzfrequenz der zweiten Gruppe übereinstimmt, und derart eingestellt wird, daß die Magnetisierungen der Kerne der ersten Gruppe und der zweiten Gruppe mindestens teilweise in einen Zustand der Mehrquanten-Kohärenz überführt werden,
- daß in unmittelbarer Folge nach dem zweiten Hochfrequenz-Impuls der dritte Hochfrequenz-Impuls als mindestens ein harter, d.h. hinsichtlich der chemischen Verschiebung nichtselektiver Impuls auf die Probe eingestrahlt und derart eingestellt wird, daß die Mehrquanten-Kohärenz in einen Zustand der korrelierten z-Ordnung überführt wird,
- daß im Zeitintervall zwischen dem dritten Hochfrequenz-Impuls und dem vierten Hochfrequenz-Impuls ein dephasierender Gradienten-Magnetfeld-Impuls auf die Probe ausgeübt wird, und
- daß der vierte Hochfrequenz-Impuls ein für die Kerne der ersten Gruppe selektiver, weicher Impuls ist und derart eingestellt wird, daß der Zustand der korrelierten z-Ordnung wieder in einen Zustand der Ein-Quanten-Kohärenz der Kerne der ersten Gruppe überführt wird, und
- daß alsdann das Resonanzsignal der Kerne der ersten Gruppe detektiert wird.

Die der Erfindung zugrundeliegende Aufgabe wird ferner dadurch gelöst,

- daß eine Impulsfolge von vier Hochfrequenz-Impulsen, vorzugsweise 90°-Hochfrequenz-Impulsen, auf die Probe eingestrahlt wird,

- daß der erste Hochfrequenz-Impuls ein für die Kerne der ersten Gruppe selektiver, weicher Impuls ist, dessen Mittenfrequenz mit der Resonanzfrequenz der ersten Gruppe übereinstimmt,

- daß der zweite Hochfrequenz-Impuls ein für die Kerne der zweiten Gruppe selektiver, weicher Impuls ist dessen Mittenfrequenz mit der Resonanzfrequenz der zweiten Gruppe übereinstimmt,und derart eingestellt wird, daß die Magnetisierungen der Kerne der ersten Gruppe und der zweiten Gruppe mindestens teilweise in einen Zustand der Mehrquanten-Kohärenz überführt werden,

- daß in unmittelbarer Folge nach dem zweiten Hochfrequenz-Impuls der dritte Hochfrequenz-Impuls als mindestens ein harter, d.h. hinsichtlich der chemischen Verschiebung nichtselektiver Impuls auf die Probe eingestrahlt und derart eingestellt wird, daß die Mehrquanten-Kohärenz in einen Zustand der korrelierten z-Ordnung überführt wird,

- daß im Zeitintervall zwischen dem dritten Hochfrequenz-Impuls und dem vierten Hochfrequenz-Impuls ein dephasierender Gradienten-Magnetfeld-Impuls auf die Probe ausgeübt wird,

- daß der vierte Hochfrequenz-Impuls ein für die Kerne der zweiten Gruppe selektiver, weicher Impuls ist und derart eingestellt wird, daß der Zustand der korrelierten z-Ordnung mittels Polarisationstransfer von den Kernen der ersten Gruppe in einen Zustand der Ein-Quanten-Kohärenz der Kerne der zweiten Gruppe überführt wird, und

- daß alsdann das Resonanzsignal der Kerne der zweiten Gruppe detektiert wird.

Das erfindungsgemäße Verfahren setzt eine sogenannte ECZOTIC-Impulsfolge (Editing via Correlated Z-Order with Total Inherent Coherence) ein, bei der alle Metaboliten-Kohärenzen selektiv in eine korrelierte Z-Ordnung oder eine longitudinale Zwei-Spin-Ordnung umgewandelt werden, ähnlich bekannten Verfahren, wie sie unter dem Schlagwort INEPT bekannt geworden sind, vgl. z.B. US-Z "Progress in NMR Spectroscopy", 16 (1983), Seite 163.

Hierbei bedeutet "z-Ordnung", daß vor dem Anlegen eines Magnetfeldgradienten die Magnetisierungen korreliert in z-Richtung (Feldrichtung) gebracht werden, so daß sie in diesen Gradienten nicht dephasieren; im Gegensatz zu den restlichen störenden Kohärenzen.

An die genannte Umwandlung schließt sich also eine Dephasierung der anderen Signale mittels gepulster Feldgradienten an, so daß die genannten Ordnungen in beobachtbare Einquanten-Kohärenzen mit maximaler Signalausbeute umgewandelt werden. Die Unempfindlichkeit von Nullquanten-Kohärenzen gegenüber einer Feld-Inhomogenität ist zwar bekannt und auch schon Grundlage von Editierverfahren gewesen, die korrelierte z-Ordnung ist jedoch, ebenso wie jedwede longitudinale Magnetisierung, ebenfalls invariant in Anwesenheit eines Feldgradienten und bietet daher einen alternativen Ansatz für ein Verfahren zum spektralen Editieren. Das erfindungsgemäße Verfahren kann grundsätzlich für jedwedes Spin-Multiplett angewendet werden, im Rahmen der vorliegenden Anmeldung soll jedoch das spektrale Editieren von Lactat und Ethanol im einzelnen beschrieben werden.

Bei einer besonders bevorzugten Ausgestaltung des erfindungsgemäßen Verfahrens ist die Probe eine Lactat-Probe oder eine Ethanol-Probe.

Dieser Anwendungsfall ist in der Biomedizin besonders bedeutsam.

Besonders bevorzugt ist, wenn der erste und der vierte Hochfrequenz-Impuls eine x-Phase und der zweite sowie der dritte Hochfrequenz-Impuls eine y-Phase aufweisen.

Nach einem weiteren besonders bevorzugten Ausführungsbeispiel der Erfindung wird in an sich bekannter Weise zur volumenselektiven Darstellung die Probe einer Folge von Gradienten-Magnetfeld-Impulsen unterschiedlicher Koordinatenrichtung ausgesetzt, und es wird mindestens ein Hochfrequenz-Impuls scheibenselektiv eingestellt.

Weiterhin ist bevorzugt, wenn in der zeitlichen Mitte zwischen dem ersten und dem zweiten Hochfrequenz-Impuls ein 180°-Impuls auf die Probe eingestrahlt wird.

Diese Maßnahme hat den Vorteil, daß die Evolution der Spins infolge einer Ablage der chemischen Verschiebung refokussiert wird.

Vorteilhafterweise wird nach dem vierten Hochfrequenz-Impuls ein zweiter 180°-Hochfrequenz-ImpulS auf die Probe eingestrahlt, und zwar bevorzugt nach einem Zeitintervall 1/4J.

Diese Maßnahme hat den Vorteil, daß im Zeitintervall zwischen dem vierten Hochfrequenz-Impuls und der Signalaufnahme die Evolution der Spins ebenfalls refokussiert wird.

Bei einer weiteren bevorzugten Variante des erfindungsgemäßen Verfahrens wird das Zeitintervall zwischen dem ersten Hochfrequenz-Impuls und dem zweiten Hochfrequenz-Impuls gleich einem ungeradzahligen Vielfachen des Kehrwertes des Zweifachen der Kopplungskonstanten zwischen der ersten Gruppe und der zweiten Gruppe bemessen.

Schließlich wird eine besonders gute Wirkung dann erzielt, wenn in an sich bekannter Weise für eine bildgebende Darstellung eine volumenselektive Messung einer Mehrzahl von Bereichen der Probe durchgeführt wird.

Ausführungsbeispiele der Erfindung sind in der Zeichnung dargestellt und werden in der nachfolgenden Beschreibung näher erläutert. Es zeigen:

Fig. 1 ein Diagramm zur Erläuterung einer Impulsfolge, wie sie im Rahmen des erfindungsgemäßen Verfahrens verwendet wird;

Fig. 2A ein 200 MHz Protonen-Spektrum von 100 mM Lithium-Lactat und Ethanol in 10 % $D_2O/H_2O$, bei einer Messung mit einem 90°-Impuls und FID-Aufnahme;

Fig. 2B das Spektrum von Fig. 2A, jedoch mit Editierung des Lactat-$CH_3$ unter Verwendung einer Nullquanten-Kohärenz-Filterung;

Fig. 2C das Spektrum der Fig. 2A, jedoch unter Verwendung einer ECZOTIC-Impulsfolge gemäß Fig. 1, wobei Frequenzen und Impulsdauern zur Editierung von Lactat eingestellt wurden;

Fig. 3A nochmals zu Vergleichszwecken ein Spektrum wie Fig. 2A;

Fig. 3B das Spektrum von Fig. 2A, jedoch mit Editierung des Ethanol-$CH_3$ unter Verwendung einer Nullquanten-Kohärenz-Filterung;

Fig. 3C das Spektrum der Fig. 2A, jedoch unter Verwendung einer ECZOTIC-Impulsfolge gemäß Fig. 1, wobei Frequenzen und Impulsdauern zur Editierung von Ethanol eingestellt wurden;

Fig. 4A ein Spektrum, aufgenommen mit einer ECZOTIC-Impulsfolge für Lactat, mit Phasenalternierung des 90°-Impulses zur Ausbildung einer Multiquanten-Kohärenz; und

Fig. 4B ein Spektrum, ähnlich wie Fig. 4A, jedoch für Ethanol mit Phasenalternierung des anfänglichen 90°-Impulses.

Allgemein gesprochen ist es ein Ziel der vorliegenden Erfindung, ein Spinsystem $X_nY_m$ zu manipulieren, wobei X und Y Protonenspins mit skalarer Kopplung sind. Innerhalb einer Hochfeld-Annäherung können die anfänglichen Spinkohärenzen durch einen Produktoperator

$$U^n S_z V^{m-1} \text{ (für } Y_m \text{)}$$

und

$$U^{n-1} I_z V^m \text{ (für } X_n \text{)}$$

beschrieben werden. U und V sind Einheiten-Operatoren, wie dies z.B. in der US-Z "Journal of Magnetic Resonance", 55 (1983), Seite 128, beschrieben ist. Unter der Annahme, daß m ≥ n ist, ergibt sich für die hier aus Gründen des Signal-Rausch-Verhältnisses interessierende Kohärenz:

$$U^n S_z V^{m-1}$$

Fig. 1 zeigt eine sogenannte ECZOTIC-Impulsfolge. Für die nachfolgende Betrachtung sei von einem Spinsystem mit n = 1 ausgegangen, wie dies z.B. in Lactat vorkommt. Die in Fig. 1 eingetragenen Evolutions-Zeiträume 1/4J und 1/2J sind jeweils vom Mittelpunkt des selektiven Impulses mit kleiner Leistung ausgemessen, die durch eine Gauss'sche Form dargestellt sind. Die in Fig. 1 eingetragene Zeit $\tau_{HS}$ für den gepulsten Homospoil-Gradienten beträgt 120 ms, und 50 ms wurden für die Einstellung des Magneten zugelassen. Für n = 1 ist i = y und für n = 2 ist i = x.

Ein erster 90°-Impuls 10 wird bei der Resonanzfrequenz ωs des $CH_3$ selektiv eingestrahlt, um die nachfolgend auftretende Unterdrückung des Wassers zu maximieren. Die sich daraus ergebenden Änderungen der Spinkohärenz nach dem Evolutionszeitraum 1/2J sind folgende:

$$mUS_zV^{m-1} \xrightarrow[\frac{\pi}{2}(\omega_s,x)]{} +mUS_yV^{m-1} \xrightarrow[1/2J]{} -mI_zS_xV^{m-1}$$

Dabei ist $\pi/2$ ($\omega_s$,x) ein selektiver "weicher" Hochfrequenz-Impuls 10 mit +x Phase, dessen Mittenfrequenz auf der Resonanzfrequenz $\omega_s$, liegt. Es ist ausreichend, wenn schmalbandige Impulse mit Gauss'scher Form verwendet werden.

Nach Ablauf einer Zeit t von 1/4J wird nun ein 180°-Hochfrequenz-Impuls 11 eingestrahlt, der ein "harter" Hochfrequenz-Impuls ist und dazu dient, um die Evolution infolge einer Ablage der chemischen Verschiebung zu refokussieren. Der 180°-Hochfrequenz-Impuls 11 kann auch scheibenselektiv eingestellt werden, nicht jedoch selektiv hinsichtlich der chemischen Verschiebung.

Ein zweiter selektiver 90°-Hochfrequenz-Impuls 12 schließt sich nach einem weiteren Zeitintervall 1/4J an. Der zweite selektive 90°-Hochfrequenz-Impuls 12 liegt in +y Phase und wird selektiv auf die Resonanzfrequenz $\omega_I$ des Lactat CH eingestrahlt. Der zweite 90°-Hochfrequenz-Impuls 12 erzeugt eine Mehrquanten-Kohärenz, die dann sofort in eine korrelierte z-Ordnung überführt wird, und zwar durch einen geeignet in der Phase eingestellten "harten" 90°-Hochfrequenz-Impuls 13, der sich unmittelbar an den zweiten "weichen" 90°-Hochfrequenz-Impuls 12 anschließt. Auch dieser "harte" 90°-Hochfrequenz-Impuls 13 kann scheibenselektiv eingestellt werden. Dabei ergibt sich:

$$-mI_zS_xV^{m-1} \xrightarrow[\frac{\pi}{2}(\omega_I,y)]{} +mI_xS_xV^{m-1} \xrightarrow[\frac{\pi}{2}(y)]{} +mI_zS_zV^{m-1}$$

Zu diesem Zeitpunkt haben alle anderen Spins, einschließlich des Wassers, nur den "harten" 90°-Hochfrequenz-Impuls 13 empfangen, der eine Einquanten-Kohärenz erzeugt. Wenn nun gepulste Magnetfeldgradienten 15 auf die Probe ausgeübt werden, dephasiert diese transversale Kohärenz, wobei die korrelierte z-Ordnung der $CH_3$-Gruppe des Lactats, $I_zS_zV^{m-1}$, unbeeinflußt bleibt. Es ist dabei aus der US-Z "Journal of Magnetic Resonance", 80 (1988), Seite 168, bekannt, eine korrelierte z-Ordnung zu erzeugen, jedoch in unterschiedlicher Weise, weil dort ein Experiment mit einer Korrelation der Besetzungsübertragung unter Ausnutzung der Phasendrehcharakteristik von Halb-Gauss'schen-Impulsen außerhalb der Resonanz ausgenutzt wurde.

Die Impulsfolge der Fig. 1 kann nun unter unterschiedlichen Gesichtspunkten fortgesetzt werden, um die korrelierte z-Ordnung in ein beobachtbares Signal zu überführen.

Nach einer ersten Variante des Impulsprogramms wird ein selektiver 90°-Hochfrequenz-Impuls 14 eingestrahlt, dessen Mittenfrequenz auf der Resonanzfrequenz $\omega_s$ liegt und eine Einquanten-Kohärenz für die $CH_3$-Spins in einem Zustand mit J-Ordnung erzeugt, der in einfacher Weise refokussiert wird, indem man eine weitere Zeitspanne 1/2J wartet, bevor ein Signal 16 aufgenommen wird, d.h.:

$$+mI_zS_zV^{m-1} \xrightarrow[\frac{\pi}{2}(\omega_s,x)]{} mI_zS_yV^{m-1} \xrightarrow[\frac{1}{2J}]{} -mUS_xV^{m-1}$$

Hierbei ist zu bemerken, daß das Endsignal der insgesamt verfügbaren Spinkohärenz der $CH_3$-Gruppe entspricht.

Nach einer anderen Variante der Impulsfolge gemäß Fig. 1 wird am Ende der Impuls 14 als ein selektiver Leseimpuls der Frequenz $\Omega_I$ eingestrahlt, der eine Einquanten-Kohärenz für die CH-Spins mittels Polarisationstransfer von der $CH_3$-Gruppe erzeugt, wobei jedoch Phasen-und Intensitäts-Verzerrungen auftreten:

$$+mI_z S_z V^{n-1} \xrightarrow[\frac{\pi}{2}(\omega_I, x)]{} +mI_y S_z V^{n-1}$$

Weiterhin kann im zeitlichen Abstand 1/4J nach dem vierten Hochfrequenz-Impuls 14 noch ein weiterer 180°-Hochfrequenz-Impuls 17 eingestrahlt werden, der ebenfalls "hart" oder scheibenselektiv eingestellt wird. Dieser Impuls 17 refokussiert die Evolution der Spins infolge einer Ablage der chemischen Verschiebung.

Fig. 2 zeigt einen Vergleich zwischen den Auswirkungen der ECZOTIC-Impulsfolge gemäß Fig. 1 und einer Spektreneditierung mit Nullquanten-Transfer für den Fall von Lactat. Man kann voraussagen, daß das durch Nullquanten-Kohärenz-Selektion erzeugte Signal um einen Faktor 4 kleiner ist als dasjenige, das mit einer ECZOTIC-Impulsfolge gemäß Fig. 1 erzeugt wird, und zwar wegen der Auswirkung der gepulsten Magnetfeldgradienten auf eine Mehrquanten-Kohärenz, wie oben erwähnt, und die Ausbildung einer Mischung aus Nullquanten-Komponenten mit x-und y-Phase, von denen jeweils nur eine zu einer Zeit in eine Einquanten-Kohärenz umgewandelt werden kann.

Die Messung der Fig. 2 wurde bei 200 MHz Protonen-Frequenz an einer Probe von 100 mM Lithium-Lactat und Ethanol in 10 % $D_2O/H_2O$ aufgenommen. Fig. 2A zeigt dabei ein übliches Spektrum mit einer einzigen Signalaufnahme unter Verwendung eines normalen 90°-Hochfrequenz-Impulses mit x-Phase. Fig. 2B zeigt demgegenüber ein Spektrum unter Editierung des Lactat-$CH_3$ mit Nullquanten-Kohärenz-Filterung, und Fig. 2C zeigt ein entsprechendes Spektrum, das unter Verwendung der Impulsfolge gemäß Fig. 1 aufgenommen wurde, wobei die Frequenzen und Impulsdauern zur Editierung des Lactats bemessen wurden.

Aus diesen Messungen erkennt man, daß das Signal/Rausch-Verhältnis der erfindungsgemäßen Messung gemäß Fig. 2C ungefähr dreimal größer ist als dasjenige, das mit einer NullquantenEditierung erhalten werden kann. Die ausgezeichnete Unterdrückung des Wassersignals um einen Faktor von mindestens 4000:1 gestattet es, den Signalempfänger mit hohem Verstärkungsfaktor zu betreiben, um auf diese Weise ein optimales Signal/Rausch-Verhältnis zu erhalten.

Wendet man nun die ECZOTIC-Impulsfolge gemäß Fig. 1 auf ein Spinsystem mit n=2 an, beispielsweise auf Ethanol, so gilt die folgende Überlegung: Die 90°-Phasenverschiebung des zweiten 90°-Hochfrequenz-Impulses 12 zur Ausbildung einer Mehrquanten-Kohärenz bei $\omega_I$ und des folgenden "harten" 90°-Hochfrequenz-Impulses 13 ist wegen der Evolution der mit den beiden I-Spins gekoppelten S-Spins der $CH_3$-Gruppe nicht erforderlich. Man findet:

$$+mU^2 S_z V^{n-1} \xrightarrow[\frac{\pi}{2}(\omega_S, x)]{} +mU^2 S_y V^{n-1} \xrightarrow[\frac{1}{2J}]{} -mI_z{}^2 S_y V^{n-1}$$

$$\xrightarrow[\frac{\pi}{2}(\omega_I, x)]{} -mI_y{}^2 S_y V^{n-1} \xrightarrow[\frac{\pi}{2}(x)]{} -mI_z{}^2 S_z V^{n-1}$$

$$\xrightarrow[\frac{\pi}{2}(\omega_S, x)]{} -mI_z{}^2 S_y V^{n-1} \xrightarrow[\frac{1}{2J}]{} +mU^2 S_y V^{n-1}$$

Auch in diesem Falle kann die korrelierte z-Ordnung wieder in eine beobachtbare Einquanten-Magnetisierung für die $CH_3$-Spins bei maximaler Signalausbeute umgewandelt werden, oder für die $CH_2$-Spins mittels Polarisationstransfer,

abhängig von der Frequenz des letzten selektiven Impulses. Dabei kann eine größtmögliche Unterdrückung des Wassers im erstgenannten Fall durch die Selektivität des Gauss'schen Leseimpulses mit der Frequenz $\omega_s$ gewährleistet werden.

Der Unterschied im Signal/Rausch-Verhältnis zwischen dem ECZOTIC-Verfahren und einer Nullquanten-Filterung kann mit einem Faktor von 8 vorhergesagt werden. Zusätzlich zu dem bereits oben genannten Faktor 4 für den Fall n=1, wird also ein weiterer Faktor von 2 bei dem Schritt der Ausbildung der Mehrquanten-Kohärenz verloren, wenn n=2 ist. Es werden nämlich sowohl Einquanten- wie auch Dreiquanten-Komponenten erzeugt und gehen anschließend während der Zeitdauer des Wirksamwerdens von Spoilgradienten verloren.

Ein Vergleich der beiden Verfahren bei der Editierung von Ethanol ist in Fig. 3 illustriert, wo Fig. 3A ein normales Spektrum mit einer Probe wie bei der Messung von Fig. 2A zeigt, Fig. 2B ein editiertes Ethanol-$CH_3$-Spektrum unter Verwendung von Nullquanten-Kohärenz-Filterung zeigt und Fig. 3C schließlich die Anwendung der ECZOTIC-Impulsfolge mit Anregung von Ethanol illustriert. Man erkennt, daß das Signal/Rausch-Verhältnis der $CH_3$-Resonanz um einen Faktor 6 besser ist.

Die Abhängigkeit des mittels einer ECZOTIC-Impulsfolge editierten Signals von der Relaxationszeit $T_2$ entsteht nur während der beiden 1/2J Evolutions-Zeitintervalle, während bei Verfahren mit Nullquanten-Filterung die interessierende Kohärenz einer $T_2$-Relaxation unterliegt, und zwar während der gesamten Pulssequenz, die aus mindestens drei 1/2J Zeitintervallen besteht. Die relativ lange homospoil-Zeit von 170 Millisekunden beruht auf der niedrigen Gradientenfeldstärke des bei den Messungen verwendeten Spektrometers. Alle verbleibenden Fehlersignale, die sich durch $T_1$-Relaxation herausbilden, können dadurch entfernt werden, daß ein Additions-/Subtraktions-Phasenzyklus am ersten selektiven 90°-Hochfrequenz-Impuls 10 im Wechselspiel mit dem Verstärker eingestellt wird. Allgemein ist zu sagen, daß die kürzere Länge der ECZOTIC-Impulssequenz die Abhängigkeit von $T_1$ und $T_2$ im Vergleich zu einer Nullquanten-Kohärenztransfer-Sequenz vermindert.

Ein wesentliches Merkmal der Spektroskopie mit korrelierter z-Ordnung ist die Wirkung der Phasendrehung des Impulses 12 zur Ausbildung einer Mehrquanten-Kohärenz und des harten Impulses 13 zur Ausbildung der z-Ordnung. Wenn n=1 ist, invertiert eine Phasendrehung des $\Pi/2\ (y,\omega_I)$-Impulses das Vorzeichen der Mehrquanten-Kohärenz und liefert damit einen Mechanismus für einen Additions-/Subtraktions-Zyklus, um verbleibende Fehlersignale zu eliminieren.

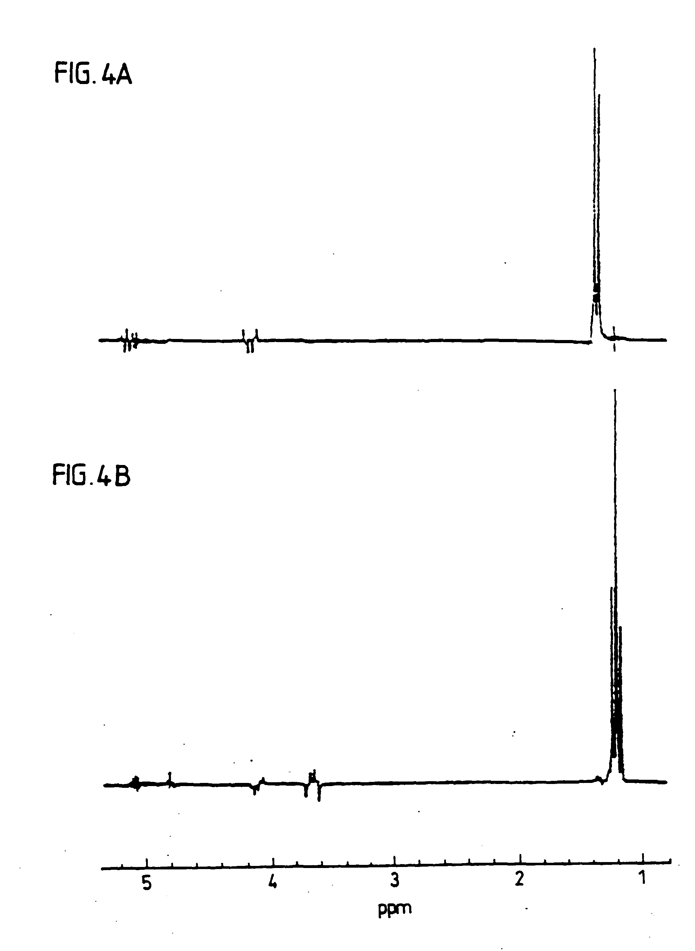

Fig. 4A zeigt ein Doppelakquisitions-Spektrum von Lactat, mit Phasenumschaltung des 90°-$(\omega_I, y)$Impulses zur Ausbildung der Mehrquantenkohärenz, Fig. 4B zeigt ein Doppelakquisitions-Spektrum von Ethanol, mit einer Phasenumschaltung des anfänglichen 90°-$(\omega_s, x)$Impulses im Einklang mit dem Empfänger.

Fig. 4A zeigt das Ergebnis eines solchen Doppelakquisitions-Phasen-Zyklus für Lactat. Wie man jedoch aus einer Betrachtung der oben erläuterten Analyse der Produktoperatoren ersieht, ändert eine Phasenumkehr des folgenden 90°-Hochfrequenz-Impulses 12 mit y-Phase nicht die Phase der korrelierten z-Ordnung, weil der Impuls 12 die Vorzeichen sowohl von $I_x$ wie auch von $S_x$ umkehrt. Das Gegenteil trifft zu, wenn n=2 ist, weil die Umkehr des selektiven Hochfrequenz-Impulses 12 zur Ausbildung der Mehrquanten-Kohärenz nicht das Vorzeichen der Mehrquanten-Kohärenz umkehrt, weil es auf eine $I_y^2$-Komponente angewendet wird. Ein Phasenwechsel des harten 90°-Hochfrequenz-Impulses 15 mit x-Phase im Wechselspiel mit dem Empfänger ist nun machbar. Eine noch wirksamere Entfernung von verbleibendem Lactat-Signal könnte noch durch Phasenumkehr des ersten selektiven 90°-Hochfrequenz-Impulses 10 der Frequenz $\omega_s$ und von x-Phase erhalten werden, wie dies im Spektrum der Fig. 4B illustriert wird.

Das verbesserte Signal/Rausch-Verhältnis, das mit dem Verfahren der vorliegenden Erfindung erzielbar ist, gibt nicht nur Anlaß zur Anwendung bei Editierstudien von hochaufgelösten Spektren wässriger Lösungen, sondern auch bei der bildgebenden Darstellung von Metaboliten und bei volumenselektiven in-vivo-Experimenten. Im wesentlichen würde man in diesem Falle zunächst die korrelierte z-Ordnung für den interessierenden Metaboliten herstellen, und der Homospoil-Feldgradient 15 gemäß Fig. 1 könnte ersetzt werden durch eine volumenselektive Sequenz, wobei dann das lokalisierte Metaboliten-Signal nach dem letzten selektiven Impuls 14 beobachtet würde.

Im Falle einer volumenselektiven Darstellung von Lactat entsteht jedoch eine Schwierigkeit dann, wenn eine Phasenumkehr pro Scheibe für einen Additions-/Subtraktions-Zyklus erforderlich ist. Im allgemeinen wird die nach dem erfindungsgemäßen Verfahren erzeugte korrelierte z-Ordnung mit dem Ausdruck $I_z^n S_z$ beschrieben. Wenn n=1 ist, wie im Falle von Lactat, kann das Vorzeichen der korrelierten z-Ordnung nicht durch einen harten 180°-Hochfrequenz-Impuls oder durch einen selektiven 180°-Hochfrequenz-Impuls in Anwesenheit eines Scheibengradienten umgekehrt werden, und zwar aus denselben Gründen, wie oben erläutert. Aus diesen Gründen ist entweder ein Verfahren zur alternativen Umkehr der Scheiben erforderlich oder die Volumenselektion muß vor der spektralen Editierung vorgenommen werden. Wenn n=2 ist, ist die korrelierte z-Ordnung stets ungerade und kann in der üblichen Weise umgekehrt werden.

Die in den Fig. 2 bis 4 dargestellten Spektren wurden auf einem 200 MHz-Spektrometer mit einem Magnetsystem von 4,7 T aufgenommen. Das Magnetsystem hatte einen nutzbaren Durchmesser von 13 Zentimetern und war mit einem Deuterium Feld-Frequenz-Lock versehen. Die selektive Anregung wurde mit einem 90°-Hochfrequenz-Impuls niedriger Leistung von 20 ms Dauer und Gauss'scher Impulsform ($f(x) = \exp(-ax^2)$, a = 3,0, abgeschnitten bei 1 %)

erzielt. Die Dauer des harten Impulses betrug typischerweise 20 µs. Die Spektren wurden an Proben in nichtrotierenden 10 mm-NMR-Röhrchen aufgenommen, die 10 % $D_2O$ enthielten. Bei denjenigen Spektren, bei denen zwei Messungen nacheinander durchgeführt wurden, betrug die Repetitionsrate 25 s. Der Homospoil-Gradient wurde durch Pulse des Raumtemperatur-Shim (z) erzeugt, was einen maximalen Gradienten von 2,7 mT/m ergab.

Weiterhin können im Rahmen der vorliegenden Erfindung auch volumenselektive Messungen durchgeführt werden. Hierzu wird mindestens einer der Hochfrequenz-Impulse 11, 13 oder 17 scheibenselektiv eingestellt und zeitgleich ein Magnetfeld-Gradienten-Impuls angelegt. Auch bildgebende Verfahren können durchgeführt werden, wie dies an sich bekannt ist. So kann beispielsweise einer der Hochfrequenz-Impulse 11 oder 13 scheibenselektiv eingestellt und im Zeitintervall zwischen dem vierten Hochfrequenz-Impuls 14 und der Signalaufnahme ein Phasengradient geschaltet werden. Entweder wird dann das Signal 16 unter einen Lesegradienten aufgenommen oder es wird im Zeitintervall nach dem vierten Hochfrequenz-Impuls 14 ein zweiter Phasengradient geschaltet, um eine Bildgebung in Abhängigkeit von der chemischen Verschiebung (chemical shift imaging) zu erhalten.

## Patentansprüche

**1.** Verfahren zur Aufnahme von Kernspinresonanzspektren von Proben mit mindestens zwei Gruppen von Kernen derselben Kernart, die über eine Kopplung miteinander wechselwirken, wobei zur alleinigen Darstellung des Signals der ersten Gruppe, z.B. $CH_3$, das Signal der zweiten Gruppe, z.B. CH, unterdrückt wird, dadurch gekennzeichnet,

- daß eine Impulsfolge von vier Hochfrequenz-Impulsen, vorzugsweise 90°-Hochfrequenz-Impulsen (10, 12, 13, 14) auf die Probe eingestrahlt wird,
- daß der erste Hochfrequenz-Impuls (10) ein für die Kerne der ersten Gruppe selektiver, weicher Impuls ist, dessen Mittenfrequenz mit der Resonanzfrequenz ($\omega_s$) der ersten Gruppe übereinstimmt,
- daß der zweite Hochfrequenz-Impuls (12) ein für die Kerne der zweiten Gruppe selektiver, weicher Impuls ist, dessen Mittenfrequenz mit der Resonanzfrequenz ($\omega_I$) der zweiten Gruppe übereinstimmt, und derart eingestellt wird, daß die Magnetisierungen der Kerne der ersten Gruppe und der zweiten Gruppe mindestens teilweise in einen Zustand der Mehrquanten-Kohärenz überführt werden,
- daß in unmittelbarer Folge nach dem zweiten Hochfrequenz-Impuls (12) der dritte Hochfrequenz-Impuls (13) als mindestens ein harter, d.h. hinsichtlich der chemischen Verschiebung nichtselektiver Impuls auf die Probe eingestrahlt und derart eingestellt wird, daß die Mehrquanten-Kohärenz in einen Zustand der korrelierten z-Ordnung überführt wird,
- daß im Zeitintervall ($\tau_{HS}$) zwischen dem dritten Hochfrequenz-Impuls (13) und dem vierten Hochfrequenz-Impuls (14) ein dephasierender Gradienten-Magnetfeld-Impuls (15) auf die Probe (30) ausgeübt wird,
- daß der vierte Hochfrequenz-Impuls (14) ein für die Kerne der ersten Gruppe selektiver, weicher Impuls ist und derart eingestellt wird, daß der Zustand der korrelierten z-Ordnung wieder in einen Zustand der Einquanten-Kohärenz der Kerne der ersten Gruppe überführt wird, und
- daß alsdann das Resonanzsignal der Kerne der ersten Gruppe detektiert wird.

**2.** Verfahren zur Aufnahme von Kernspinresonanzspektren von Proben mit mindestens zwei Gruppen von Kernen derselben Kernart, die über eine Kopplung miteinander wechselwirken, wobei zur alleinigen Darstellung des Signals der zweiten Gruppe, z.B. CH, das Signal der ersten Gruppe, z.B. $CH_3$, unterdrückt wird, dadurch gekennzeichnet,

- daß eine Impulsfolge von vier Hochfrequenz-Impulsen, vorzugsweise 90°-Hochfrequenz-Impulsen (10, 12, 13, 14) auf die Probe eingestrahlt wird,
- daß der erste Hochfrequenz-Impuls (10) ein für die Kerne der ersten Gruppe selektiver, weicher Impuls ist, dessen Mittenfrequenz mit der Resonanzfrequenz ($\omega_s$) der ersten Gruppe übereinstimmt,
- daß der zweite Hochfrequenz-Impuls (12) ein für die Kerne der zweiten Gruppe selektiver, weicher Impuls ist,

dessen Mittenfrequenz mit der Resonanzfrequenz ($\omega_I$) der zweiten Gruppe übereinstimmt, und derart eingestellt wird, daß die Magnetisierungen der Kerne der ersten Gruppe und der zweiten Gruppe mindestens teilweise in einen Zustand der Mehrquanten-Kohärenz überführt werden,

- daß in unmittelbarer Folge nach dem zweiten Hochfrequenz-Impuls (12) der dritte Hochfrequenz-Impuls (13) als mindestens ein harter, d.h. hinsichtlich der chemischen Verschiebung nichtselektiver Impuls auf die Probe eingestrahlt und derart eingestellt wird, daß die Mehrquanten-Kohärenz in einen Zustand der korrelierten z-Ordnung überführt wird,

- daß im Zeitintervall ($\tau_{HS}$) zwischen dem dritten Hochfrequenz-Impuls (13) und dem vierten Hochfrequenz-Impuls (14) ein dephasierender Gradienten-Magnetfeld-Impuls (15) auf die Probe (30) ausgeübt wird,

- daß der vierte Hochfrequenz-Impuls (14) ein für die Kerne der zweiten Gruppe selektiver, weicher Impuls ist und derart eingestellt wird, daß der Zustand der korrelierten z-Ordnung über Polarisationstransfer von den Kernen der ersten Gruppe in einen Zustand der Einquanten-Kohärenz der Kerne der zweiten Gruppe überführt wird, und

- daß alsdann das Resonanzsignal der Kerne der zweiten Gruppe detektiert wird.

**3.** Verfahren nach Anspruch 1 oder 2, dadurch gekennzeichnet, daß die Probe eine Lactat-Probe oder eine Ethanol-Probe ist.

**4.** Verfahren nach einem der Ansprüche 1 bis 3, dadurch gekennzeichnet, daß der erste Hochfrequenz-Impuls (10) eine x-Phase, der zweite Hochfrequenz-Impuls (12) eine y-Phase, der dritte Hochfrequenz-Impuls (13) eine y-Phase und der vierte Hochfrequenz-Impuls (14) wiederum eine x-Phase aufweist.

**5.** Verfahren nach einem oder mehreren der Ansprüche 1 bis 4, dadurch gekennzeichnet, daß in der zeitlichen Mitte zwischen dem ersten und dem zweiten Hochfrequenz-Impuls (10, 12) ein erster 180°-Hochfrequenz-Impuls (11) auf die Probe eingestrahlt wird.

**6.** Verfahren nach einem oder mehreren der Ansprüche 1 bis 5, dadurch gekennzeichnet, daß nach dem vierten Hochfrequenz-Impuls (14) ein zweiter 180°-Hochfrequenz-Impuls (17) auf die Probe eingestrahlt wird.

**7.** Verfahren nach einem oder mehreren der Ansprüche 1 bis 6, dadurch gekennzeichnet, daß in an sich bekannter Weise zur volumenselektiven Darstellung die Probe einer Folge von Gradienten-Magnetfeld-Impulsen unterschiedlicher Koordinatenrichtung (x, y, z) ausgesetzt wird und daß mindestens ein Hochfrequenz-Impuls (11, 13, 17) scheibenselektiv eingestellt wird.

**8.** Verfahren nach einem oder mehreren der Ansprüche 1 bis 7, dadurch gekennzeichnet, daß das Zeitintervall zwischen dem ersten Hochfrequenz-Impuls (10) und dem zweiten Hochfrequenz-Impuls (12) gleich einem ungeradzahligen Vielfachen des Kehrwertes des Zweifachen der Kopplungskonstanten (J) zwischen der ersten Gruppe und der zweiten Gruppe bemessen wird.

**9.** Verfahren nach einem oder mehreren der Ansprüche 7 oder 8, dadurch gekennzeichnet, daß in an sich bekannter Weise eine bildgebende Darstellung durchgeführt wird.

**Claims**

**1.** A method of recording nuclear spin resonance spectra of samples having at least two groups of nuclei of the same nuclear kind interacting with each other via a coupling, wherein, for solely editing the signal of the first group, e.g. $CH_3$, the signal of the second group, e.g. CH is suppressed, characterized in that,

- a pulse sequence of four rf pulses, preferably of 90° rf pulses (10, 12, 13, 14) is irradiated on the sample;

- the first rf pulse (10) is a soft pulse being selective for the nuclei of the first group, the center frequency of which coinciding with the resonance frequency ($\omega_s$) of the first group;

- the second rf pulse (12) is a soft pulse being selective for the nuclei of the second group, the center frequency of which coinciding with the resonance frequency ($\omega_I$) of the second group and being set such that the magnetizations of the nuclei of the first group and of the second group are at least partially transferred into a multiple quantum coherence state;

- immediately after the second rf pulse (12) the third rf pulse (13) is irradiated as at least one hard pulse, i.e. a pulse being non-selective with respect to the chemical shift, and is set such that the multiple quantum coherence is transferred into a correlated z-order state;

- during the time interval ($\tau_{HS}$) between the third rf pulse (13) and the fourth rf pulse (14) a dephasing gradient magnetic field pulse (15) is exerted on the sample (30);

- the fourth rf pulse (14) is a soft pulse being selective for the nuclei of the first group, and is set such that the correlated z-order state is again transferred into a single quantum coherence state of the nuclei of the first group; and

- thereafter the resonance signal of the nuclei of the first group is detected.

**2.** A method of recording nuclear spin resonance spectra of samples having at least two groups of nuclei of the same nuclear kind interacting with each other via a coupling, wherein, for solely editing the signal of the second group, e.g. CH, the signal of the first group, e.g. $CH_3$ is suppressed, characterized in that,

- a pulse sequence of four rf pulses, preferably of 90° rf pulses (10, 12, 13, 14) is irradiated on the sample;

- the first rf pulse (10) is a soft pulse being selective for the nuclei of the first group, the center frequency of which coinciding with the resonance frequency ($\omega_s$) of the first group;

- the second rf pulse (12) is a soft pulse being selective for the nuclei of the second group, the center frequency of which coinciding with the resonance frequency ($\omega_I$) of the second group and being set such that the magnetizations of the nuclei of the first group and of the second group are at least partially transferred into a multiple quantum coherence state;

- immediately after the second rf pulse (12) the third rf pulse (13) is irradiated as at least one hard pulse, i.e. a pulse being non-selective with respect to the chemical shift, and is set such that the multiple quantum coherence is transferred into a correlated z-order state;

- during the time interval ($\tau_{HS}$) between the third rf pulse (13) and the fourth rf pulse (14) a dephasing gradient magnetic field pulse (15) is exerted on the sample (30);

- the fourth rf pulse (14) is a soft pulse being selective for the nuclei of the second group, and is set such that the correlated z-order state is again transferred into a single quantum coherence state of the nuclei of the second group via polarization transfer; and

- thereafter the resonance signal of the nuclei of the second group is detected.

**3.** The method of claims 1 or 2, characterized in that the sample is a lactate sample or an ethanol sample.

**4.** The method of any of claims 1 through 3, characterized in that the first rf pulse (10) has an x phase, that the second rf pulse (12) has an y phase, that the third rf pulse (13) has an y phase and that the fourth rf pulse (14) again has an x phase.

**5.** The method of any of claims 1 through 4, characterized in that a first 180° pulse (11) is irradiated on the sample in the middle of time between the first and the second rf pulse (10, 13).

**6.** The method of any of claims 1 through 5, characterized in that a second 180° rf pulse (17) is irradiated on the sample after the fourth rf pulse (14).

**7.** The method of any of claims 1 through 6, characterized in that for a volume selective display, the sample is exerted

to a sequence of gradient magnetic field pulses of different coordinate direction (x, y, z) and at least one rf pulse (11, 13, 17) is set to be slice selective, as known per se.

**8.** The method of any of claims 1 through 7, charcterized in that the time interval between the first rf pulse (10) and the second rf pulse (12) is set to be equal to an odd multiple of the reciprocal value of the coupling constant (J) between the first group and the second group.

**9.** The method of claim 7 or 8, characterized in that an imaging display is effected, as known per se.

**Revendications**

**1.** Procédé d'enregistrement de spectres de résonance magnétique nucléaire sur des échantillons comportant au moins deux groupes de noyaux de même type de noyau, qui réagissent mutuellement au moyen d'un couplage, le signal du second groupe, par exemple CH, étant supprimé pour permettre la représentation exclusive du signal du premier groupe, par exemple $CH_3$, caractérisé en ce que :

- une suite d'impulsions constituée par quatre impulsions haute fréquence, de préférence des impulsions haute fréquence à 90° (10, 12, 13, 14) est envoyée sur l'échantillon,
- la première impulsion haute fréquence (10) est une impulsion moins dure, plus sélective pour les noyaux du premier groupe, et dont la fréquence centrale correspond à la fréquence de résonance ($\omega_S$) du premier groupe,
- la deuxième impulsion haute fréquence (12) est une impulsion moins dure, plus sélective pour les noyaux du deuxième groupe, dont la fréquence centrale correspond à la fréquence de résonance ($\omega_I$) du deuxième groupe, et qui est réglée de telle sorte que les magnétisations des noyaux du premier groupe et du deuxième groupe sont transposées, au moins partiellement, dans un état de cohérence de quanta multiples,
- immédiatement à la suite de la deuxième impulsion haute fréquence (12), la troisième impulsion haute fréquence (13) est envoyée sur l'échantillon, au moins en tant qu'impulsion plus dure, c'est-à-dire non sélective en ce qui concerne le déplacement chimique, et qui est réglée de telle sorte que l'état de cohérence de quanta multiples est transposé dans un état de l'ordre z corrélatif,
- dans l'intervalle de temps ($\tau_{HS}$) entre la troisième impulsion haute fréquence (13) et la quatrième impulsion haute fréquence (14), l'échantillon (30) est soumis à une impulsion déphasante de champ magnétique à gradients (15),
- la quatrième impulsion haute fréquence (14) est une impulsion moins dure, plus sélective pour les noyaux du premier groupe, et qui est réglée de telle sorte que les noyaux du premier groupe sont à nouveau transposés de l'état de l'ordre z corrélatif dans un état de cohérence de quanta simples, et
- le signal de résonance des noyaux du premier groupe est alors détecté.

**2.** Procédé d'enregistrement de spectres de résonance magnétique nucléaire sur des échantillons comportant au moins deux groupes de noyaux de même type de noyau, qui réagissent mutuellement au moyen d'un couplage, le signal du premier groupe, par exemple $CH_3$, étant supprimé pour permettre la représentation exclusive du signal du second groupe, par exemple CH, caractérisé en ce que :

- une suite d'impulsions constituée par quatre impulsions haute fréquence, de préférence des impulsions haute fréquence à 90° (10, 12, 13, 14) est envoyée sur l'échantillon,
- la première impulsion haute fréquence (10) est une impulsion moins dure, plus sélective pour les noyaux du premier groupe, et dont la fréquence centrale correspond à la fréquence de résonance ($\omega_S$) du premier groupe,
- la deuxième impulsion haute fréquence (12) est une impulsion moins dure, plus sélective pour les noyaux du deuxième groupe, dont la fréquence centrale correspond à la fréquence de résonance ($\omega_I$) du deuxième groupe, et qui est réglée de telle sorte que les magnétisations des noyaux du premier groupe et du deuxième groupe sont transposées, au moins partiellement, dans un état de cohérence de quanta multiples,

- immédiatement à la suite de la deuxième impulsion haute fréquence (12), la troisième impulsion haute fréquence (13) est envoyée sur l'échantillon, au moins en tant qu'impulsion plus dure, c'est-à-dire non sélective en ce qui concerne le déplacement chimique, et qui est réglée de telle sorte que l'état de cohérence de quanta multiples est transposé dans un état de l'ordre z corrélatif,

- dans l'intervalle de temps ($\tau_{HS}$) entre la troisième impulsion haute fréquence (13) et la quatrième impulsion haute fréquence (14), l'échantillon (30) est soumis à une impulsion déphasante de champ magnétique à gradients (15),

- la quatrième impulsion haute fréquence (14) est une impulsion moins dure, plus sélective pour les noyaux du premier groupe, et qui est réglée de telle sorte que les noyaux du premier groupe sont à nouveau transposés de l'état de l'ordre z corrélatif dans un état de cohérence de quanta simples, et

- le signal de résonance des noyaux du deuxième groupe est alors détecté.

**3.** Procédé selon l'une ou l'autre des revendications 1 et 2, caractérisé en ce que l'échantillon est un échantillon de lactate ou un échantillon d'éthanol.

**4.** Procédé selon l'une quelconque des revendications 1 à 3, caractérisé en ce que la première impulsion haute fréquence (10) est de phase x, la deuxième impulsion haute fréquence (12) de phase y, la troisième impulsion haute fréquence (13) de phase y, et la quatrième impulsion haute fréquence (14) à nouveau de phase x.

**5.** Procédé selon l'une ou plusieurs des revendications 1 à 4, caractérisé en ce que, au milieu du laps de temps qui sépare la première de la deuxième des impulsions haute fréquence (10, 12), une première impulsion haute fréquence à 180° (11) est envoyée sur l'échantillon.

**6.** Procédé selon l'une ou plusieurs des revendications 1 à 5, caractérisé en ce que, après la quatrième impulsion haute fréquence (14), une deuxième impulsion haute fréquence à 180° (17) est envoyée sur l'échantillon.

**7.** procédé selon l'une ou plusieurs des revendications 1 à 6, caractérisé en ce que, de façon connue, pour la représentation à sélection de volume de l'échantillon, celui-ci est soumis à une suite d'impulsions de champ magnétique à gradients selon des axes de coordonnées différents (x, y, z), et en ce que réglage d'une impulsion haute fréquence (11, 13, 17) au moins, est à sélection de tranche.

**8.** Procédé selon l'une ou plusieurs des revendications 1 à 7, caractérisé en ce que l'intervalle de temps qui sépare la première impulsion haute fréquence (10) de la deuxième impulsion haute fréquence (12) est réglé de façon à être égal à un multiple impair de l'inverse du double de la constante de couplage (J) entre le premier groupe et le deuxième groupe.

**9.** Procédé selon la revendication 7 et/ou la revendication 8, caractérisé en ce que, de façon connue, une représentation visuelle est effectuée.

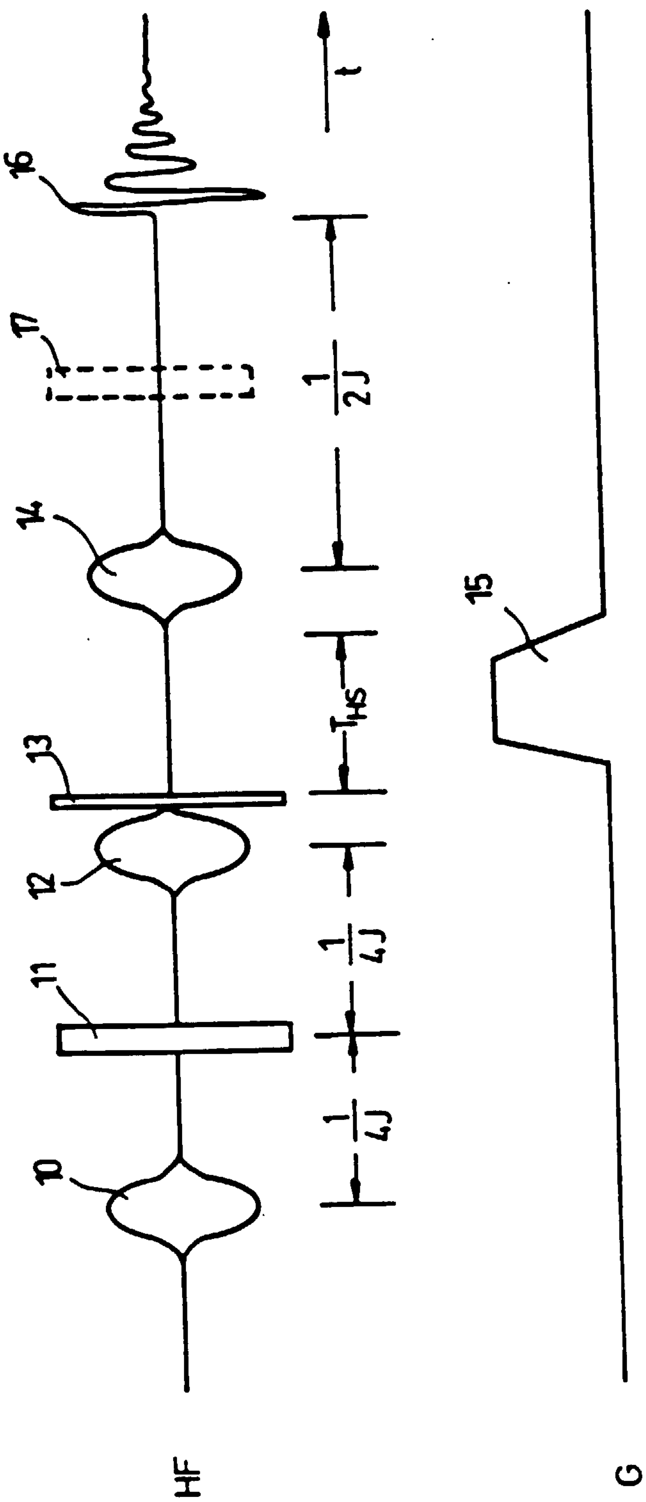


FIG.1

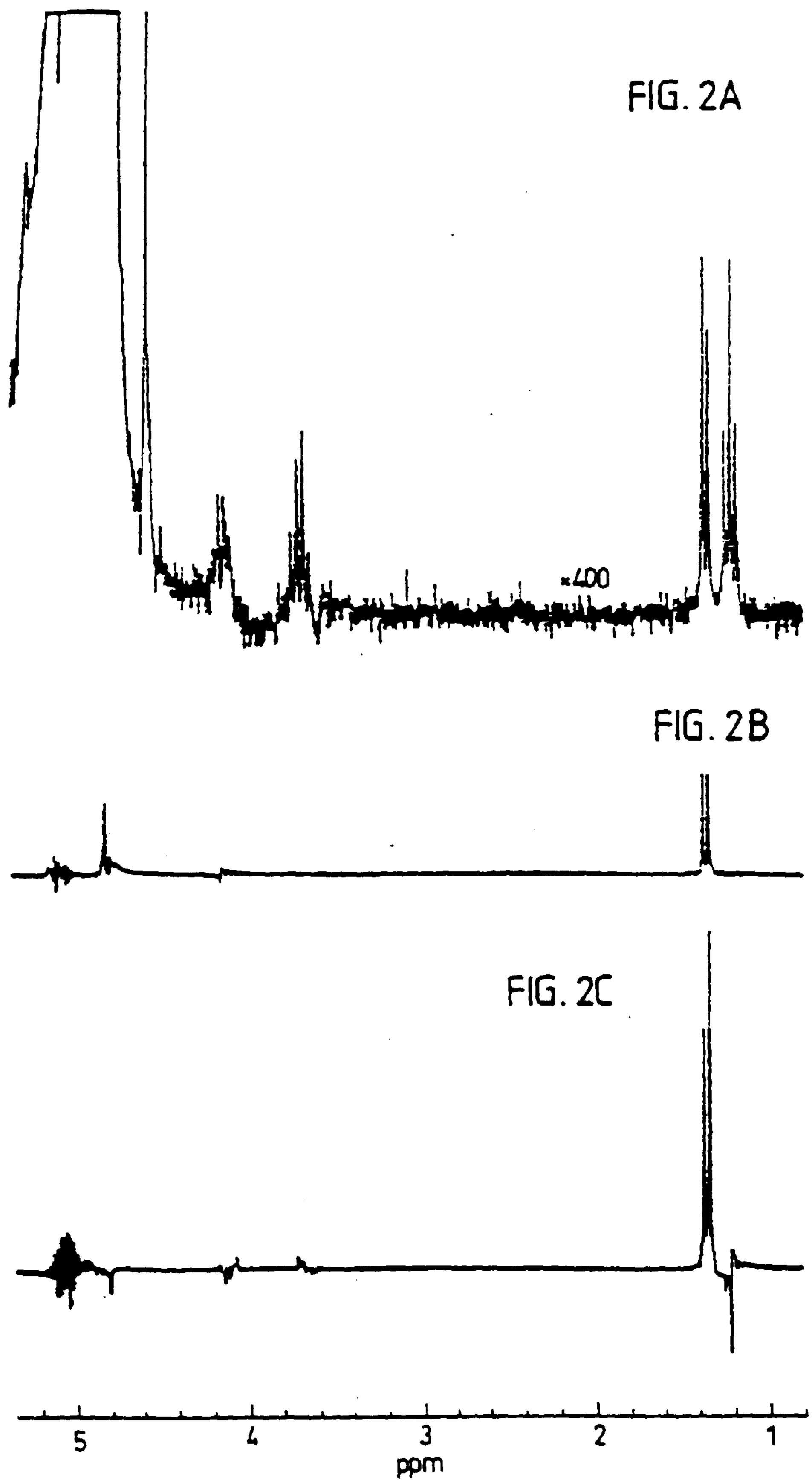
FIG. 2A
×400
FIG. 2B
FIG. 2C
5
4
3
2
1
ppm

FIG.3A

FIG.3B

FIG.3C

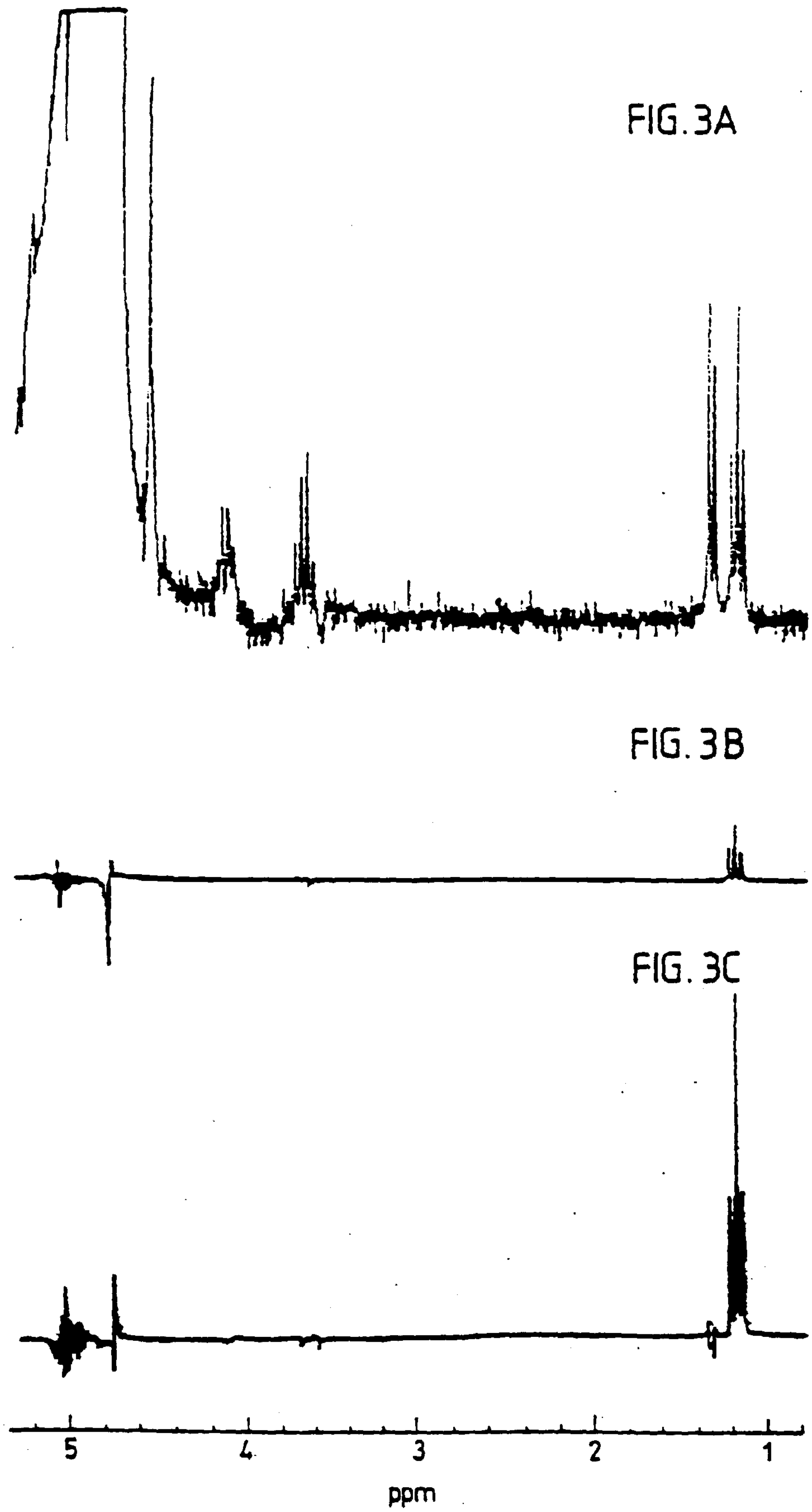

FIG. 4A

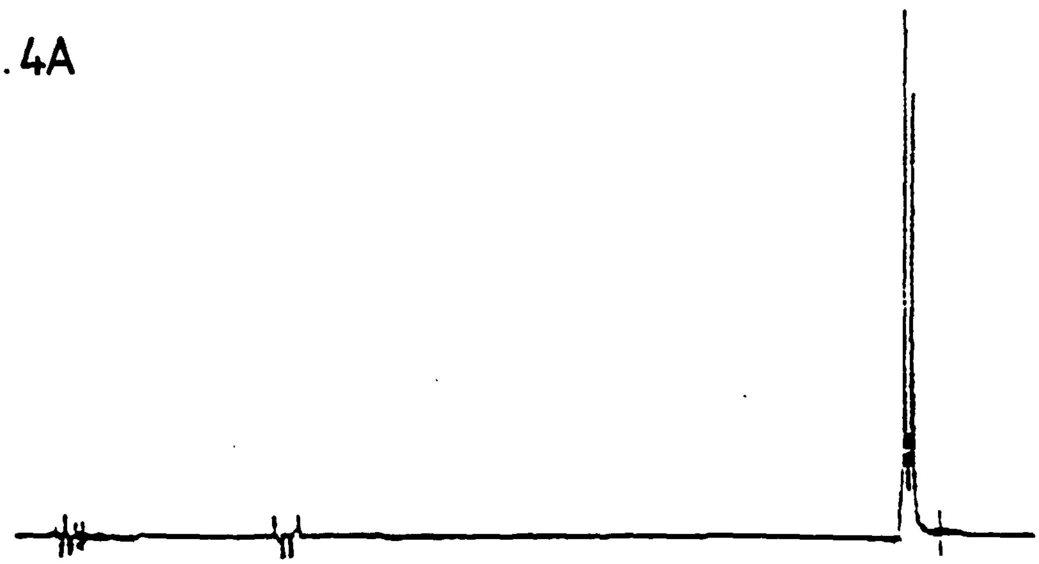

FIG. 4B